# EUROPEAN PATENT SPECIFICATION

(11) **EP 2 315 235 B1**
(45) Date of publication and mention of the grant of the patent: **24.04.2019**
(21) Application number: 09173658.7
(22) Date of filing: 21.10.2009
(51) Int. Cl.: H01L 21/67, H01L 21/02, B08B 3/02, B08B 3/12

(54) **Method and apparatus for cleaning a semiconductor substrate**
Verfahren und Vorrichtung zur Reinigung eines Halbleitersubstrats
Procédé et appareil de nettoyage d'un substrat semiconducteur

(43) Date of publication of application: 27.04.2011
(73) Proprietor: IMEC VZW, 3001 Leuven (BE)
(72) Inventor: Mertens, Paul, B-2820, Bonheiden (BE); Brems, Steven, B-3000, Leuven (BE)
(74) Representative: Pronovem

(56) References cited:
- JP-A- 3 171 727
- JP-A- 2007 311 756
- US-A1- 2002 009 015
- US-A1- 2004 226 654

## Description

### Field of the Invention

The invention is related to a method and apparatuses for cleaning a substrate, in particular a semiconductor substrate, by bringing the substrate in contact with a cleaning fluid and applying acoustic energy to the fluid.

### State of the art.

Ultrasonic and megasonic wafer cleaning methods are known in the semiconductor industry, in particular for cleaning silicon wafers. The general principle is to bring the wafer into contact with a cleaning liquid, usually by submerging the wafer in a liquid-filled tank, and to apply acoustic energy to the cleaning liquid, by way of an electromechanical transducer. Most known applications use acoustic waves in the ultrasonic (<200kHz) or megasonic (up to or above 1MHz) frequency range. The acoustic energy causes cavitation, i.e. the creation of bubbles that oscillate or even collapse. The bubbles assist in the removal of particles from the wafer surface, due to the drag forces created by the bubble formation, the oscillation, or by drag forces created when bubbles become unstable and collapse. However, current techniques suffer from a number of problems. At ultrasonic frequencies, bubbles tend to be large and collapse more heavily, leading to an increased risk of damaging the substrate and the structures present on it. Megasonic cleaning leads to smaller bubbles and lower damage risk. However, as the structures present in integrated circuits are made smaller each new generation of technology, the damage risk remains. On the other hand, when the bubbles are too small, they do not sufficiently contribute to the removal of particles from the wafer surface.

Document US2004/0226654 is related to a substrate cleaning apparatus comprising a substrate holder and a processing head provided with cathodes and anodes disposed opposited the substrate held by the substrate holder. A cleaning liquid is supplied between the processing head and the substrate to be cleaned, and a pulsed voltage is applied between the anodes and cathodes, to generate microbubbles of O₂ or O₃ in the cleaning liquid. Ultrasonic transducers are further provided, to generate ultrasonic waves which cause microbubbles to collapse, creating microjet flows. These microjet flows remove particles adhered to the substrate surface.

### Aims of the invention

The invention aims to propose a method and apparatus for cleaning a semiconductor substrate by the action of cavitation bubbles under the influence of acoustic energy, wherein the risk of damaging the substrate is reduced, whilst ensuring a good particle removing capability.

### Summary of the invention

The invention is related to methods and apparatuses as disclosed in the appended claims.

The invention is thus related to a system in accordance with appended claim 1.

When the system is used in combination with a particular cleaning liquid, at least the nucleation sites exhibit a higher contact angle contact with said cleaning liquid than the surface to be cleaned. When the cleaning liquid is water, the nucleation sites preferably have a higher hydrophobicity than the surface to be cleaned. The material of the nucleation structure may be non-porous or porous with respect to the cleaning liquid. The nucleation structure may be a porous substrate wherein the pores at the surface of the substrate form said nucleation sites.

Said nucleation structure is a nucleation substrate hereafter called 'template', having a front and back side, the nucleation surface being on the front side, said nucleation surface comprising a pattern of cavities, said cavities forming bubble nucleation sites.

Said template may comprises an electrode, said electrode forming the bottom of said cavities or being electrically connected to the bottom of said cavities, and wherein the apparatus further comprises a voltage source or means to connect the apparatus to a voltage source, so as to apply a voltage difference between said electrode and the surface to be cleaned, while said space is filed by said liquid.

According to an embodiment, the nucleation structure comprises channels, each channel extending between the back of the template and the bottom of one of said cavities, the apparatus further comprising a supply means for supplying a gaseous substance, so that said substance flows from the back of the template, through the channels, to the cavities, while said space is filled by said liquid.

According to another embodiment, said nucleation structure is a membrane having pores or openings (22), configured to act as nucleation sites.

According to one embodiment, an apparatus applicable in a system according to the invention comprises :
- a tank which can be filled with said cleaning liquid,
- a means for mounting said substrate and said nucleation structure in said tank,
- a transducer arranged on the underside or on a side wall of said tank, for producing said acoustic force.

According to another embodiment, an apparatus applicable in a system according to the invention comprises :
- means for holding a single substrate, having a surface to be cleaned,
- a supply means for supplying cleaning liquid onto the surface to be cleaned,
- a means for mounting said nucleation structure so that a liquid film may be formed between the nucleation surface and the surface to be cleaned,
- a transducer arranged in contact with the nucleation structure, for producing said acoustic force.

The apparatus according to the latter embodiment may further comprise a rotatable holder for the substrate to be cleaned, so as to rotate the substrate around its central axis perpendicular to the surface to be cleaned, and said supply means may be arranged to supply liquid to the surface to be cleaned while the substrate is rotating.

In an apparatus applicable in a system according to the invention, said nucleation structure may be configured to remain stationary with respect to said substrate, while said substrate is subjected to said acoustic force.

An apparatus applicable in a system according to the invention may further comprise a means for moving said nucleation structure with respect to said substrate, while said liquid is subjected to said acoustic force.

The invention is equally related to a method for cleaning a semiconductor substrate with a cleaning liquid in accordance with appended claim 9.

According to an embodiment, said substrate to be cleaned and said nucleation structure are submerged in a tank filled with said cleaning liquid, before subjecting the liquid to said acoustic force.

According to another embodiment, said acoustic force are produced by a transducer so as to produce acoustic waves propagating through the liquid in a propagating direction perpendicular to a transducer surface, and said substrate and nucleation structure are placed at an angle with respect to said propagation direction, said angle being chosen so as to maximize the transmission of acoustic energy through the substrate to be cleaned.

According to an embodiment of the method according to the invention, said nucleation structure is arranged in proximity to said surface to be cleaned, and wherein a film of said cleaning liquid is formed between the nucleation structure and the surface to be cleaned.

### Brief description of the figures

Figure 1 shows a cleaning system according to a first embodiment of the invention.
Figure 2 illustrates the cleaning mechanism in a system according to the invention.
Figure 3 shows a system according to the invention, having a bubble nucleation membrane.
Figure 4 illustrates the bubble formation using a nucleation membrane.
Figure 5 shows a system according to the invention, having a movable bubble nucleation structure.
Figure 6 shows a system having a nucleation structure comprising an electrode.
Figure 7 shows a system according to the invention, wherein the substrate and the nucleation structure are mounted at an angle.
Figure 8 illustrates the relation between the orientation of a substrate and the acoustic reflectivity coefficient.
Figure 9 shows a system according to another embodiment of the invention, involving the formation of a film of liquid on a substrate to be cleaned.
Figure 10 shows a system according to an embodiment of the invention, involving microchannels formed in a nucleation structure.

### Detailed description of the invention

In a method and system of the invention, a substrate is brought into contact with a cleaning liquid, e.g. submerged in a tank containing said cleaning liquid, and an oscillating acoustic force is applied to the liquid, in a manner known in the art, sending acoustic waves through the liquid. Characteristic to the invention is the presence of a nucleation structure, comprising a nucleation surface facing (preferably parallel to) the surface to be cleaned, said nucleation surface comprising nucleation sites for the formation of cavitation bubbles under the influence of the acoustic waves travelling through the liquid. Nucleation sites are locations which exhibit an increased affinity for bubble formation due to the topography of the surface, e.g. as a consequence of holes or pores, as will be explained on the basis of the embodiments described hereafter. The material of the nucleation surface or at least of those parts of the surface corresponding to the nucleation sites, exhibit(s) a higher contact angle when in contact with the cleaning liquid than the substrate surface. When the cleaning liquid is water, this means that the structure is more hydrophobic than the substrate.

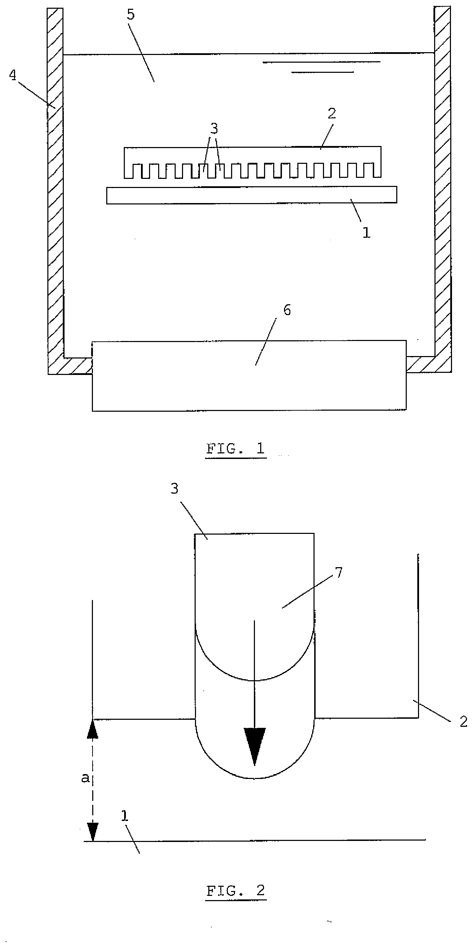

Figure 1 shows a first embodiment of the invention, where the structure is provided in the form of a 'bubble template' 2, which is a patterned substrate placed in close vicinity and substantially parallel to the substrate 1 to be cleaned. The pattern consists of a plurality of small cavities 3, obtained for example by etching, in the template's surface, said cavities serving as nucleation sites for the bubble formation. The cavities 3 may be present over the totality of or on a portion of the template surface. The template is held at a fixed distance to the substrate by appropriate holding means (not shown). In the embodiment of figure 1, the substrate-template assembly is mounted in a tank 4, which can be filled with a cleaning liquid 5, and wherein an electromechanical transducer 6 is attached to the bottom of the tank. The transducer can also be attached to the side of the tank, submerged in the tank or it can be directly connected to template 2. A transducer can be used of a type known in the art, for example as described in patent documents US 6,904,921 or US5,355,048.

The amount by which the pressure increases (or decreases) in the cleaning liquid as a sound wave travels through it is called pressure amplitude. The pressure amplitude of the acoustic waves may be situated in a range which causes transient cavitation, i.e. wherein bubbles grow to their maximum size and collapse at a certain distance from the substrate surface, thereby causing a strong microscopic streaming which results in drag forces working on the substrate surface. Simulations indicate that in the case of oxygen bubbles in water, when a pressure amplitude of 3 bar is applied at a frequency of 1 MHz, the bubbles with an initial diameter of about 500 nm in diameter grow to about 3.5 micron in diameter before collapsing. Alternatively, the pressure amplitude may be lower so that a stable oscillating bubble formation is obtained: bubbles growing from a minimum to a maximum size and back, at the frequency of the applied acoustic force.

Figure 2 illustrates the way in which the cleaning takes place: bubbles 7 are present in the cavities or nucleate on the template and not on the substrate, due to the presence of the nucleation sites. The bubble formation on the template is further enhanced when there is a difference in (hydro)phobicity. Transient bubble behaviour induces strong microscopic streaming which results in drag forces working on the substrate surface. Because the bubbles are nucleated on the template, the majority of the bubbles do not collapse onto the substrate, thereby reducing the risk of damaging the substrate. In this way it becomes possible to apply higher acoustic forces/energies, able to remove particles effectively, without damaging the substrate surface. When a stable oscillating bubble regime is obtained (not transient) on the template, the drag forces working on the substrate to be cleaned are reduced as a result of the distance between the bubble and the substrate surface, so that a higher amplitude/energy may be applied without damaging the substrate.

The distance a (fig. 2) between the template and the substrate is in the order of 1 to a few 100 of micrometers, depending on the maximum size of the bubbles. It is preferred that said distance is about one to ten times said maximum bubble diameter. This also makes it possible to adjust the drag forces by adjusting the distance a. The maximum bubble size depends on the pressure amplitude and frequency. Any value of the distance a defines a resonance frequency at which the bubbles reach the highest maximum size before collapsing. It is a preferred mode of operation to work within such a resonance regime in order to maximize the cleaning effect, even though the invention is not limited to such a mode of operation.

The size of the cavities 3 is not drawn on a realistic scale in figure 1, nor is the shape of the cavities limited to the embodiment illustrated in figure 1. The cavities may have the shape of a truncated cone, a cylinder, a truncated pyramid or a prism. The material and shape are optimized to act as efficient nucleation sites for bubbles to be created. The cavities may have a circular cross-section having a diameter in the order of nanometres or micrometers, depending on the size of bubbles which are being produced and the pressure amplitudes that are applied. For example, holes with a 4□m diameter can be used in combination with a 1MHz acoustic force at an amplitude of 3bar. The distance between holes 3 on the template surface may vary between the cavity diameter and ∼10 times the bubble radius.

The template 2 is an example of the nucleation structure referred to in appended claim 1. In stead of a patterned substrate, any structure can be used having a surface comprising nucleation sites for bubble formation. For example, a substrate with a surface having a high roughness (for example a black Si substrate) can be used given that the peaks and troughs of the roughness profile also constitute nucleation sites. Moreover, it has been proven that a considerable roughness in itself renders a surface more (hydro)phobic compared to a smooth surface. Besides a solid substrate, a substrate may be used provided with a layer having a suitable roughness, for example a Si-substrate provided with a layer of porous low-K dielectric material.

The material from which the nucleation structure is made can be a non-porous material, i.e. non-porous for the cleaning liquid. Alternatively, the nucleation structure can be made from a porous material, for example porous Teflon. A porous material will allow more liquid to enter the space between the template and the substrate when the substrate and template are submerged in the liquid, thereby ensuring a steady bubble formation. Also dissolved gas, expected to assist bubble formation, can be supplied through the porous material. When a porous material is used, the pores which are located at the surface of the structure may themselves constitute nucleation sites, i.e. a porous nucleation structure may take on the form of a flat substrate (not provided with a pattern of cavities), and wherein the pores themselves are forming bubble nucleation sites.

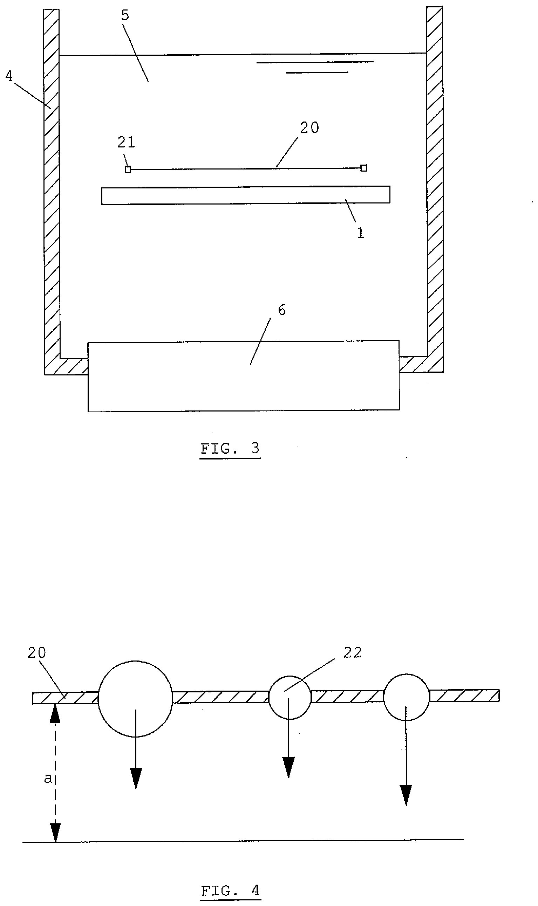

The nucleation structure may be a porous membrane in stead of a solid structure, see figure 3, which shows a membrane 20 mounted in a frame 21. With porous membrane is meant a thin layer of a material with openings throughout the thickness of the layer. It may be a membrane made from a porous material, wherein the openings are a consequence of the porosity of the material, or a membrane provided with a net-like pattern of openings. The openings serve as nucleation sites for bubble formation, as illustrated in figure 4. A GORE™ membrane could be suitable for use in the present invention.

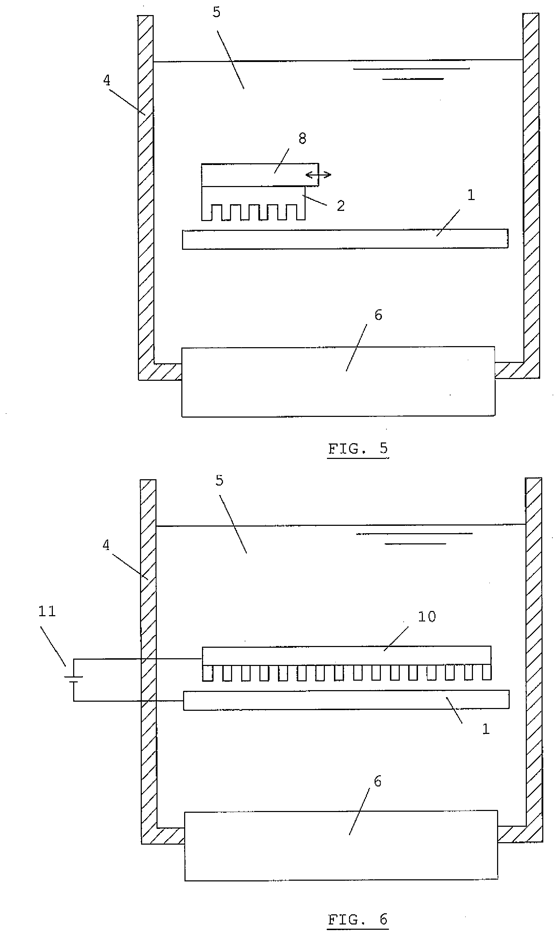

The template 2 (or any nucleation structure according to claim 1) may be stationary with respect to the substrate, or movable. A stationary template may have a surface which is smaller, equal or larger than the substrate surface. In one case, the template has a circular surface, placed concentrically with the surface of a round wafer. The surface of a movable template is smaller than the substrate surface, see figure 5. It is configured in cooperation with a drive means 8 to move the template over the surface of the substrate, preferably whilst remaining parallel to the substrate surface.

According to another embodiment, the nucleation structure may be a bubble template as shown in figure 6, comprising an electrode 10, and wherein the bottom of the bubble nucleation cavities is formed by said electrode. When the electrode 10 and the substrate 1 are coupled to an electric power source 11 while being submerged in the cleaning liquid having an appropriate composition, electrolysis takes place so that gas bubbles are produced in said cavities. In this way, bubble formation is facilitated as gas bubbles are generated in situ.

Another way of obtaining in-situ gas generation is by choosing a cleaning solution with a composition comprising reactive components. For example, in a solution comprising NH₄OH and H₂O₂, these elements will react to form NH₃ and O₂ in gaseous form. This reaction will thus generate gas bubbles in the cleaning liquid. In order to enhance such reactions, the bottom and possibly also the sidewalls of the cavities may be provided with a catalyst for the reaction in question. The catalyst may be applied in the form of a coating. A manganesedioxide coating serves as a catalyst for the decomposition of H₂O₂ in H₂O and O₂.

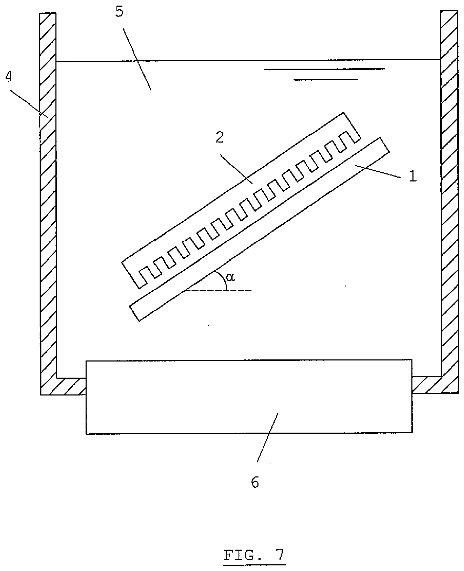

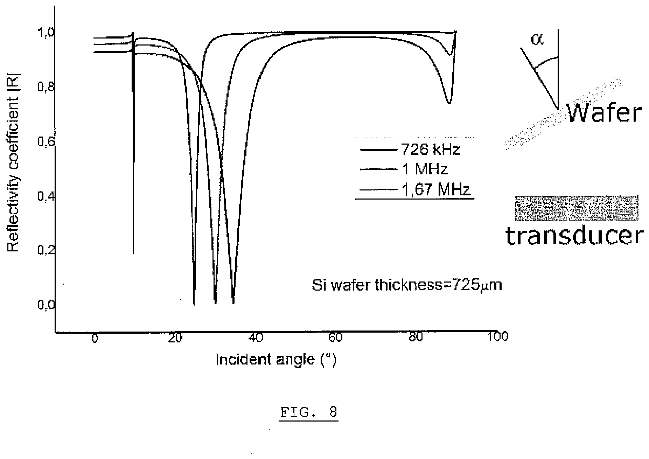

Figure 7 shows an embodiment wherein the substrate and template are positioned at an angle ∝ with respect to the transducer surface, i.e. the surface which is perpendicular to the propagation direction of the acoustic waves produced by the transducer. It has been shown that the acoustic reflection characteristics of a thin silicon substrate, here referred to as a wafer, are highly dependent on the orientation of the wafer with respect to the propagation direction of acoustic waves. As seen in figure 8, a sharp drop in reflectivity coefficient is observed, and thus a peak in transmission of acoustic energy through the Si-wafer, depending on the frequency of the applied waves. The position of the peak is further dependent on the wafer thickness, the acoustic impedances of the wafer and the cleaning liquid, said impedances being themselves dependent on the angle of incidence, density, Young's modulus and Poisson's ratio. Based on this knowledge, it is advantageous to place the substrate and template under an angle corresponding to the transmission peak, so that a maximum of acoustic energy reaches the space between the Si-wafer and the template.

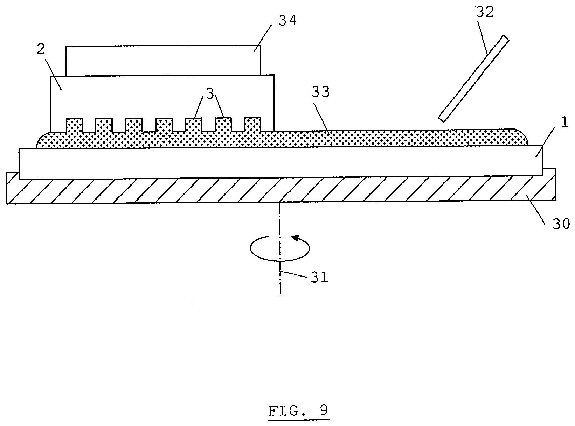

The above methods have been described in combination with an apparatus wherein a substrate is submerged in a tank filled with a cleaning liquid. According to another embodiment, the contact between the nucleation structure and the substrate on the one hand and the cleaning liquid on the other hand is obtained by providing a film of liquid between the nucleation structure and the substrate. Any of the nucleation structures described above can be applied in this embodiment. Figure 9 shows the case wherein a nucleation template 2 is used, i.e. a substrate provided with a pattern of cavities 3 on the surface. The substrate 1 is mounted in a substrate holder 30, arranged to hold the substrate firmly in place and further arranged to rotate the substrate around a central rotation axis 31. Any suitable type of rotatable substrate holder known in the art may be used for this purpose. A cleaning liquid supply means, such as a nozzle 32 is provided for supplying liquid to the surface of the substrate. The nucleation template 2 is arranged in close proximity and substantially parallel to the substrate surface, at a distance to the surface which allows the build-up of a film 33 of liquid between the substrate and the template. The template is preferably stationary but may also be movable in a direction parallel to the substrate surface. The template may have any suitable shape, e.g. it may be in the shape of a beam or arm arranged parallel to the substrate surface. The rotation of the substrate causes liquid to flow off the substrate, while fresh liquid is supplied via the liquid supply 32. An electromechanical transducer 34 is attached to the bubble template, to cause acoustic waves of given frequency to appear in the liquid film. The generation of bubbles and the cleaning action caused by said bubbles takes place as in the embodiment described above.

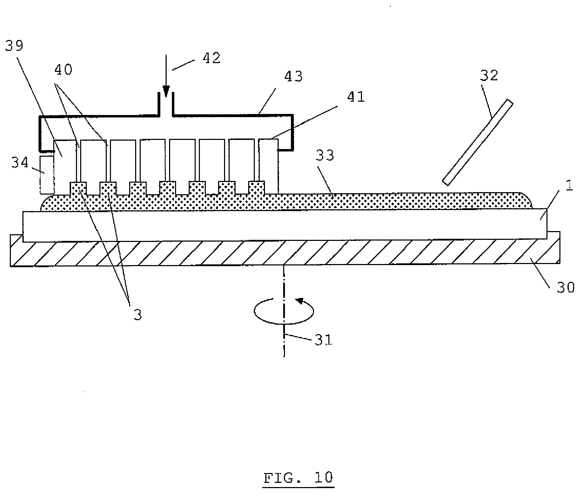

According to another embodiment, illustrated in figure 10, the nucleation structure 39 is a substrate, for example a patterned substrate provided with a pattern of cavities 3 as described above, and further provided with a plurality of channels 40 connecting the back surface 41 of the nucleation structure to the bottom of the holes. Channels 40, also referred to as microchannels, may be of a diameter smaller than the diameter of the cavities 3, as shown, or they may have a diameter larger than the cavities, or corresponding to the cavities, in which case the microchannels run throughout the thickness of the template. The microchannels are further connected to a supply 42 of a gaseous substance, thereby directing a gas flow towards the bottom of the holes, while the nucleation surface is in contact with a cleaning liquid. In the embodiment shown in figure 10, the cleaning liquid is present as a liquid film, as already described in relation to figure 9. A gas supply collector 43 may be applied in order to guide the gas supply towards the microchannels. The gas supply greatly enhances the formation of gas bubbles at the bottom of the holes, said bubbles developing further under the influence of an acoustic force, generated by an electromechanical transducer 34 attached to the nucleation structure. This embodiment can also be used in combination with a tank filled with a cleaning liquid, provided that appropriate measures are taken to bring the gas supply to the microchannels while the substrate and nucleation structure are submerged in the liquid.

## Claims

1. A system comprising a substrate (1) with a surface to be cleaned and an apparatus for cleaning one or more semiconductor substrates (1), the apparatus comprising :
• a means for holding the substrate (1) having a surface to be cleaned,
• a nucleation structure (2,39), comprising a nucleation surface having nucleation sites (3,22) for bubble formation when in contact with a cleaning liquid,
• a means for mounting said nucleation structure with its nucleation surface facing said surface to be cleaned,
• a means for supplying a cleaning liquid to as to substantially fill the space between the surface to be cleaned and the nucleation surface,
• a means (6) for subjecting said liquid, while present in said space, to an oscillating acoustic force,
wherein said nucleation structure is a nucleation substrate hereafter called 'template' (2), having a front and back side, the nucleation surface being on the front side, said nucleation surface comprising a pattern, consisting of a plurality of small cavities (3), said cavities forming bubble nucleation sites, i.e. locations which exhibit an increased affinity for bubble formation due to the topography of the nucleation surface, said nucleation sites exhibiting a higher contact angle when in contact with the cleaning liquid than the substrate surface to be cleaned, so that bubbles nucleate on the template and not on said substrate (1) having a surface to be cleaned, due to the presence of the nucleation sites.

2. System according to claim 1, wherein when the apparatus is used in combination with water as the cleaning liquid, at least the nucleation sites exhibit a higher hydrophobicity than the surface to be cleaned.

3. System according to claim 1 or 2, wherein the template (2) comprises an electrode (10), said electrode forming the bottom of said cavities (3) or being electrically connected to the bottom of said cavities, and wherein the apparatus further comprises a voltage source (11) or means to connect the apparatus to a voltage source, so as to apply a voltage difference between said electrode (10) and the surface to be cleaned, while said space is filed by said liquid.

4. System according to claim 1 or 2, wherein the nucleation structure (2) comprises channels (40), each channel extending between the back of the template and the bottom of one of said cavities (3), the apparatus further comprising a supply means for supplying a gaseous substance (42), so that said substance flows from the back of the template, through the channels (40), to the cavities (3), while said space is filled by said liquid.

5. System according to any one of claims 1 to 3, wherein the apparatus comprises :
• a tank (4) which can be filled with said cleaning liquid (5),
• a means for mounting said substrate (1) and said nucleation structure (2) in said tank (4),
• a transducer (6) arranged on the underside or on a side wall of said tank, for producing said acoustic force.

6. System according to any one of claims 1 to 3, wherein the apparatus comprises :
• a means for holding a single substrate (1), having a surface to be cleaned,
• a supply means (32) for supplying cleaning liquid onto the surface to be cleaned,
• a means for mounting said nucleation structure (2) so that a liquid film (33) may be formed between the nucleation surface and the surface to be cleaned,
• a transducer (34) arranged in contact with the nucleation structure, for producing said acoustic force.

7. System according to any one of claims 1 to 6, wherein said nucleation structure (2) is configured to remain stationary with respect to said substrate (1), while said substrate is subjected to said acoustic force.

8. System according to any one of claims 1 to 6, wherein the apparatus further comprises a means (8) for moving said nucleation structure (2) with respect to said substrate, while said liquid is subjected to said acoustic force.

9. A method for cleaning a semiconductor substrate (1) with a cleaning liquid (5,33), comprising the steps of
• Providing and holding a substrate (1) comprising a surface to be cleaned,
• Providing a nucleation structure (2, 39) comprising a nucleation surface having nucleation sites (3,22) for bubble formation when in contact with said cleaning liquid (5,33),
• mounting said nucleation structure (2) so that the nucleation surface is facing said surface to be cleaned,
• bringing said nucleation surface and said surface to be cleaned into contact with said cleaning liquid (5,33), by substantially filling the space between the substrate and the nucleation surface,
• subjecting said cleaning liquid to an oscillating acoustic force, thereby obtaining bubbles (7) in said liquid, said bubbles nucleating on the surface of the nucleation structure, and said bubbles causing drag forces acting on the surface to be cleaned,
wherein said nucleation structure is a nucleation substrate hereafter called 'template' (2), having a front and back side, the nucleation surface being on the front side, said nucleation surface comprising a pattern, consisting of a plurality of small cavities (3), said cavities forming bubble nucleation sites, i.e. locations which exhibit an increased affinity for bubble formation due to the topography of the nucleation surface, said nucleation sites exhibiting a higher contact angle when in contact with the cleaning liquid than the substrate surface to be cleaned, so that bubbles nucleate on the template and not on said substrate comprising a surface to be cleaned, due to the presence of the nucleation sites.

10. Method according to claim 9, wherein at least said nucleation sites (3,22) exhibit a higher hydrophobicity than the surface to be cleaned, when the cleaning liquid is water.

11. Method according to claim 9 or 10, wherein said substrate (1) to be cleaned and said nucleation structure (2,20,39) are submerged in a tank (4) filled with said cleaning liquid (5), before subjecting the liquid to said acoustic force.

12. Method according to claim 11, wherein said acoustic force is produced by a transducer (6) so as to produce acoustic waves propagating through the liquid in a propagating direction perpendicular to a transducer surface, and wherein said substrate and nucleation structure are placed at an angle with respect to said propagation direction, said angle being chosen so as to maximize the transmission of acoustic energy through the substrate to be cleaned.

13. Method according to any one of claims 9 to 12, wherein said nucleation structure is arranged in proximity to said surface to be cleaned, and wherein a film (33) of said cleaning liquid is formed between the nucleation structure (2) and the surface to be cleaned.

## Patentansprüche

1. System, umfassend ein Substrat (1), mit einer Fläche, die gereinigt werden soll, und eine Vorrichtung zur Reinigung eines oder mehrerer Halbleitersubstrate (1), wobei die Vorrichtung Folgendes umfasst:
• ein Mittel zum Halten des Substrats (1), das eine Fläche aufweist, die gereinigt werden soll,
• eine Keimbildungsstruktur (2, 39), umfassend eine Keimbildungsfläche, die Keimbildungsstellen (3, 22) zur Blasenbildung aufweist, wenn sie mit einer Reinigungsflüssigkeit in Kontakt ist,
• ein Mittel zur Montage der Keimbildungsstruktur, wobei die Keimbildungsfläche der Fläche, die gereinigt werden soll, gegenüber liegt,
• ein Mittel, um an dieselbe eine Reinigungsflüssigkeit zuzuführen, um im Wesentlichen den Raum zwischen der Fläche, die gereinigt werden soll, und der Keimbildungsfläche zu füllen,
• ein Mittel (6), um die Flüssigkeit, während sie in dem Raum anwesend ist, einer oszillierenden akustischen Kraft zu unterziehen,
wobei die Keimbildungsstruktur ein Keimbildungssubstrat ist, das im Folgenden als "Schablone" (2) bezeichnet wird, aufweisend eine vordere und hintere Seite, wobei sich die Keimbildungsfläche auf der vorderen Seite befindet, wobei die Keimbildungsfläche ein Muster umfasst, das aus einer Vielzahl von kleinen Hohlräumen (3) besteht, wobei die Hohlräume Blasen-Keimbildungsstellen bilden, d. h. Stellen, die eine erhöhte Affinität zur Blasenbildung aufgrund der Topographie der Keimbildungsfläche zeigen, wobei die Keimbildungsstellen einen höheren Kontaktwinkel zeigen, wenn sie in Kontakt mit der Reinigungsflüssigkeit sind, als das Substrat, das gereinigt werden soll, so dass Blasen auf der Schablone und nicht auf dem Substrat (1), das eine Fläche aufweist, die gereinigt werden soll, aufgrund der Anwesenheit der Keimbildungsstellen keimen.

2. System nach Anspruch 1, wobei, wenn die Vorrichtung in Kombination mit Wasser als Reinigungsflüssigkeit verwendet wird, zumindest die Keimbildungsstellen eine höhere Hydrophobizität als die Fläche, die gereinigt werden soll, zeigen.

3. System nach Anspruch 1 oder 2, wobei die Schablone (2) eine Elektrode (10) umfasst, wobei die Elektrode den Boden der Hohlräume (3) bildet oder elektrisch mit dem Boden der Hohlräume verbunden ist, und wobei die Vorrichtung weiter eine Spannungsquelle (11)oder Mittel umfasst, um die Vorrichtung an die Spannungsquelle zu verbinden, um eine Spannungsdifferenz zwischen der Elektrode (10) und der Fläche, die gereinigt werden soll, anzuwenden, während der Raum mit der Flüssigkeit gefüllt ist.

4. System nach Anspruch 1 oder 2, wobei die Keimbildungsstruktur (2) Kanäle (40) umfasst, wobei sich jeder Kanal zwischen der Hinterseite der Schablone und dem Boden eines der Hohlräume (3) erstreckt, wobei das Gerät weiter ein Zufuhrmittel umfasst, um eine gasförmige Substanz (42) zuzuführen, so dass die Substanz von der Hinterseite der Schablone durch die Kanäle (40) an die Hohlräume (3) fließt, während der Raum mit der Flüssigkeit gefüllt ist.

5. System nach einem der Ansprüche 1 bis 3, wobei die Vorrichtung Folgendes umfasst:
• einen Tank (4), der mit der Reinigungsflüssigkeit (5) gefüllt werden kann,
• ein Mittel, um das Substrat (1) und die Keimbildungsstruktur (2) in dem Tank (4) zu montieren,
• einen Wandler (6), der auf der Unterseite oder auf einer Seitenwand des Tanks angeordnet ist, um die akustische Kraft zu erzeugen.

6. System nach einem der Ansprüche 1 bis 3, wobei die Vorrichtung Folgendes umfasst:
• ein Mittel zum Halten eines einzelnen Substrats (1), das eine Fläche aufweist, die gereinigt werden soll,
• ein Zufuhrmittel (32), um Reinigungsflüssigkeit an die Fläche, die gereinigt werden soll, zuzuführen,
• ein Mittel, um die Keimbildungsstruktur (2) zu montieren, so dass ein Flüssigkeitsfilm (33) zwischen der Keimbildungsfläche und der Fläche, die gereinigt werden soll, gebildet werden kann,
• einen Wandler (34), der in Kontakt mit der Keimbildungsstruktur angeordnet ist, um die akustische Kraft zu erzeugen.

7. System nach einem der Ansprüche 1 bis 6, wobei die Keimbildungsstruktur (2) konfiguriert ist, um stationär mit Bezug auf das Substrat (1) zu bleiben, während das Substrat der akustischen Kraft unterzogen wird.

8. System nach einem der Ansprüche 1 bis 6, wobei die Vorrichtung weiter ein Mittel (8) umfasst, um die Keimbildungsstruktur (2) mit Bezug auf das Substrat zu bewegen, während die Flüssigkeit der akustischen Kraft unterzogen wird.

9. Verfahren zur Reinigung eines Halbleitersubstrats (1) mit einer Reinigungsflüssigkeit (5, 33), umfassend die folgenden Schritte:
• Bereitstellen und Halten eines Substrats (1), das eine Fläche umfasst, die gereinigt werden soll,
• Bereitstellen einer Keimbildungsstruktur (2, 39), umfassend eine Keimbildungsfläche, die Keimbildungsstellen (3, 22) zur Blasenbildung aufweist, wenn sie mit der Reinigungsflüssigkeit (5, 33) in Kontakt ist,
• Montieren der Keimbildungsstruktur (2), so dass die Keimbildungsfläche der Fläche, die gereinigt werden soll, gegenüber liegt,
• In-Kontakt-Bringen der Keimbildungsfläche und der Fläche, die gereinigt werden soll, mit der Reinigungsflüssigkeit (5, 33), durch im Wesentlichen Füllen des Raums zwischen dem Substrat und der Keimbildungsfläche,
• Unterziehen der Reinigungsflüssgkeit einer oszillierenden akustischen Kraft, dadurch Erhalten von Blasen (7) in der Flüssigkeit, wobei die Blasen auf der Fläche der Keimbildungsstruktur keimen und die Blasen Zugkräfte verursachen, die auf die Fläche, die gereinigt werden soll, wirken,
wobei
die Keimbildungsstruktur ein Keimbildungssubstrat ist, das im Folgenden als "Schablone" (2) bezeichnet wird, aufweisend eine vordere und hintere Seite, wobei sich die Keimbildungsfläche auf der vorderen Seite befindet, wobei die Keimbildungsfläche ein Muster umfasst, das aus einer Vielzahl von kleinen Hohlräumen (3) besteht, wobei die Hohlräume Blasen-Keimbildungsstellen bilden, d. h. Stellen, die eine erhöhte Affinität zur Blasenbildung aufgrund der Topographie der Keimbildungsfläche aufweisen, wobei die Keimbildungsstellen einen höheren Kontaktwinkel zeigen, wenn sie in Kontakt mit der Reinigungsflüssigkeit stehen, als das Substrat, das gereinigt werden soll, so dass Blasen auf der Schablone und nicht auf dem Substrat, das eine Fläche umfasst, die gereinigt werden soll, aufgrund der Anwesenheit der Keimbildungsstellen keimen.

10. Verfahren nach Anspruch 9, wobei mindestens die Keimbildungsstellen (3, 22) eine höhere Hydrophobizität als die Fläche, die gereinigt werden soll, zeigen, wenn die Renigungsflüssigkeit Wasser ist.

11. Verfahren nach Anspruch 9 oder 10, wobei das Substrat (1), das gereinigt werden soll, und die Keimbildungsstruktur (2, 20, 39) in einen Tank (4) getaucht werden, der mit der Reinigungsflüssigkeit (5) gefüllt ist, bevor die Flüssigkeit der akustischen Kraft unterzogen wird.

12. Verfahren nach Anspruch 11, wobei die akustische Kraft durch einen Wandler (6) erzeugt wird, um akustische Wellen zu erzeugen, die sich durch die Flüssigkeit in einer Verbreitungsrichtung verbreiten, die senkrecht zu einer Wandlerfläche ist, und wobei das Substrat und die Keimbildungsstruktur in einen Winkel mit Bezug auf die Verbreitungsrichtung platziert werden, wobei der Winkel derart ausgewählt wird, dass er die Übertragung der akustischen Energie durch das Substrat, das gereinigt werden soll, maximiert.

13. Verfahren nach einem der Ansprüche 9 bis 12, wobei die Keimbildungsstruktur benachbart der Fläche, die gereinigt werden soll, angeordnet wird, und wobei ein Film (33) der Reinigungsflüssigkeit zwischen der Keimbildungsstruktur (2) und der Fläche, die gereinigt werden soll, gebildet wird.

## Revendications

1. Système qui comprend un substrat (1) avec une surface à nettoyer et un appareil destiné à nettoyer un ou plusieurs substrats semi-conducteurs (1), l'appareil comprenant :
• un moyen destiné à maintenir le substrat (1) ayant une surface à nettoyer,
• une structure de nucléation (2 ; 39), qui comprend une surface de nucléation ayant des sites de nucléation (3, 22) pour la formation de bulles lors du contact avec un liquide de nettoyage,
• un moyen destiné à monter ladite structure de nucléation avec sa surface de nucléation qui fait face à ladite surface à nettoyer,
• un moyen destiné à fournir un liquide de nettoyage de façon à remplir sensiblement l'espace entre la surface à nettoyer et la surface de nucléation,
• un moyen (6) destiné à soumettre ledit liquide, tant qu'il est présent dans ledit espace, à une force acoustique oscillante,
dans lequel ladite structure de nucléation est un substrat de nucléation nommé ci-après « gabarit » (2), ayant une face avant et une face arrière, la surface de nucléation étant sur la face avant, ladite surface de nucléation comprenant un motif, consistant en une pluralité de petites cavités (3), lesdites cavités formant des sites de nucléation de bulles, c'est-à-dire des emplacements qui présentent une plus grande affinité pour la formation de bulles en raison de la topographie de la surface de nucléation, lesdits sites de nucléation présentant un angle de contact plus élevé lors du contact avec le liquide de nettoyage que la surface de substrat à nettoyer, de sorte que les bulles soient nucléées sur le gabarit et non sur ledit substrat (1) ayant une surface à nettoyer, en raison de la présence de sites de nucléation.

2. Système selon la revendication 1, dans lequel, lorsque l'appareil est utilisé en combinaison avec de l'eau comme liquide de nettoyage, au moins les sites de nucléation présentent une hydrophobicité plus grande que la surface à nettoyer.

3. Système selon la revendication 1 ou la revendication 2, dans lequel le gabarit (2) comprend une électrode (10), ladite électrode formant le fond desdites cavités (3) ou étant reliée électriquement au fond desdites cavités, et dans lequel l'appareil comprend en outre une source de tension (11) ou un moyen destiné à relier l'appareil à une source de tension, de façon à appliquer une différence de tension entre ladite électrode (10) et la surface à nettoyer, pendant que ledit liquide remplit ledit espace.

4. Système selon la revendication 1 ou la revendication 2, dans lequel la structure de nucléation (2) comprend des canaux (40), chaque canal s'étendant entre l'arrière du gabarit et le fond de l'une desdites cavités (3), l'appareil comprenant en outre un moyen de distribution d'une substance gazeuse (42), de sorte que ladite substance circule entre l'arrière du gabarit, par le biais des canaux (40), et les cavités (3), pendant que ledit espace est rempli par le liquide.

5. Système selon l'une quelconque des revendications 1 à 3, dans lequel l'appareil comprend :
• un réservoir (4) qui peut être rempli avec ledit liquide de nettoyage (5),
• un moyen destiné à monter ledit substrat (1) et ladite structure de nucléation (2) dans ledit réservoir (4),
• un transducteur (6) disposé sur la partie inférieure ou sur une paroi latérale dudit réservoir, pour produire ladite force acoustique.

6. Système selon l'une quelconque des revendications 1 à 3, dans lequel l'appareil comprend :
• un moyen destiné à maintenir un seul substrat (1), ayant une surface à nettoyer,
• un moyen de distribution (32) pour fournir du liquide de nettoyage sur la surface à nettoyer,
• un moyen destiné à monter ladite structure de nucléation (2) de sorte qu'un film liquide (33) puisse être formé entre la surface de nucléation et la surface à nettoyer,
• un transducteur (34) disposé en contact avec la structure de nucléation, pour produire ladite force acoustique.

7. Système selon l'une quelconque des revendications 1 à 6, dans lequel ladite structure de nucléation (2) est configurée pour rester stationnaire par rapport audit substrat (1), pendant que ledit substrat est soumis à ladite force acoustique.

8. Système selon l'une quelconque des revendications 1 à 6, dans lequel l'appareil comprend en outre un moyen (8) destiné à déplacer ladite structure de nucléation (2) par rapport audit substrat, pendant que ledit liquide est soumis à ladite force acoustique.

9. Procédé de nettoyage d'un substrat semi-conducteur (1) avec un liquide de nettoyage (5, 33), qui comprend les étapes suivantes:
• prévoir et maintenir un substrat (1) comprenant une surface à nettoyer,
• prévoir une structure de nucléation (2, 39) comprenant une surface de nucléation ayant des sites de nucléation (3, 22) pour la formation de bulles lors du contact avec ledit liquide de nettoyage (5, 33),
• monter ladite structure de nucléation (2) de sorte que la surface de nucléation soit face à ladite surface à nettoyer,
• amener ladite surface de nucléation et ladite surface à nettoyer en contact avec ledit liquide de nettoyage (5, 33), en remplissant sensiblement l'espace entre le substrat et la surface de nucléation,
• soumettre ledit liquide de nettoyage à une force acoustique oscillante, afin d'obtenir des bulles (7) dans ledit liquide, lesdites bulles étant nucléées sur la surface de la structure de nucléation, et lesdites bulles provoquant des forces de résistance qui agissent sur la surface à nettoyer,
dans lequel ladite structure de nucléation est un substrat de nucléation nommé ci-après « gabarit » (2), ayant une face avant et une face arrière, la surface de nucléation étant sur la face avant, ladite surface de nucléation comprenant un motif, consistant en une pluralité de petites cavités (3), lesdites cavités formant des sites de nucléation de bulles, c'est-à-dire des emplacements qui présentent une plus grande affinité pour la formation de bulles en raison de la topographie de la surface de nucléation, lesdits sites de nucléation présentant un angle de contact plus élevé lors du contact avec le liquide de nettoyage que la surface de substrat à nettoyer, de sorte que les bulles soient nucléées sur le gabarit et non sur ledit substrat ayant une surface à nettoyer, en raison de la présence de sites de nucléation.

10. Procédé selon la revendication 9, dans lequel au moins lesdits sites de nucléation (3, 22) présentent une hydrophobicité plus grande que la surface à nettoyer, lorsque le liquide de nettoyage est de l'eau.

11. Procédé selon la revendication 9 ou la revendication 10, dans lequel ledit substrat (1) à nettoyer et ladite structure de nucléation (2, 20, 39) sont immergés dans un réservoir (4) rempli avec ledit liquide de nettoyage (5), avant de soumettre le liquide à ladite force acoustique.

12. Procédé selon la revendication 11, dans lequel ladite force acoustique est produite par un transducteur (6) de façon à produire des ondes acoustiques se propageant à travers le liquide dans une direction de propagation perpendiculaire à une surface du transducteur, et dans lequel ledit substrat et ladite structure de nucléation sont placés à un angle par rapport à ladite direction de propagation, ledit angle étant choisi de façon à maximiser la transmission de l'énergie acoustique à travers le substrat à nettoyer.

13. Procédé selon l'une quelconque des revendications 9 à 12, dans lequel ladite structure de nucléation est disposée à proximité de ladite surface à nettoyer, et dans lequel un film (33) dudit liquide de nettoyage est formé entre la structure de nucléation (2) et la surface à nettoyer.
